# EUROPEAN PATENT APPLICATION

(11) **EP 4 404 280 A1**
(43) Date of publication of application: **24.07.2024**
(21) Application number: 22869761.1
(22) Date of filing: 23.08.2022
(51) Int. Cl.: H01L 31/0236, H01L 31/0747, H10K 30/80

(54) **SOLAR CELL**

(30) Priority: 14.09.2021 JP 2021149306
(71) Applicant: KANEKA CORPORATION, Osaka 530-8288 (JP)
(72) Inventor: KOJIMA Kohei, Settsu-shi, Osaka 566-0072 (JP); HINO Masashi, Settsu-shi, Osaka 566-0072 (JP); ISHIBASHI Hirotaka, Settsu-shi, Osaka 566-0072 (JP); MISHIMA Ryota, Settsu-shi, Osaka 566-0072 (JP)
(74) Representative: Hoffmann Eitle
(86) International application number: PCT/JP2022/031723
(87) International publication number: WO 2023/042614

(57) **Abstract**

A solar cell according to one embodiment of the present invention has high photoelectric conversion efficiency and comprises a semiconductor substrate 11, and a first semiconductor layer 14 having first conductivity and a second semiconductor layer 15 having second conductivity that are each layered on the semiconductor substrate 11. The material volume Vmp at 10% of the load area of at least a first main surface of the semiconductor substrate 11 is 0.003 µm³/µm² to 0.010 µm³/µm².

## Description

### TECHNICAL FIELD

The present invention relates to a solar cell.

### BACKGROUND ART

Use of solar cells is expanding as an energy source with a small environmental load. When a solar cell is installed in various devices, vehicles, buildings, and the like, the photoelectric conversion efficiency of the solar cell can be important because the installation area is limited. As a method of improving the photoelectric conversion efficiency of a solar cell, a technique of forming a texture structure having a large number of pyramidal projections-recesses on a main surface of a semiconductor substrate is known (for example, see Patent Document 1).

By forming the texture structure on a surface of the semiconductor substrate and, furthermore, on a light receiving surface, the reflectance of light can be reduced and a larger amount of light can be introduced into the inside, resulting in improvement in the photoelectric conversion efficiency. For example, a transparent electrode can be stacked on a light-receiving surface side of a semiconductor substrate, but by using a film forming technique such as vacuum vapor deposition or sputtering, a material can be uniformly stacked on the semiconductor substrate to maintain the texture structure.

As another method for improving the photoelectric conversion efficiency of a solar cell, a solar cell is also known, which includes a perovskite solar cell, such as an organic photoelectric conversion layer including a perovskite compound, stacked on a light receiving surface of a crystalline silicon solar cell formed using a semiconductor substrate (for example, see Patent Document 2).

### Citation List

### Patent Document

Patent Document 1: Japanese Unexamined Patent Application, Publication No. 2021-57435
Patent Document 2: Japanese Unexamined Patent Application, Publication No. 2018-163959

### DISCLOSURE OF THE INVENTION

### Problems to be Solved by the Invention

Generally, the organic photoelectric conversion layer of a perovskite solar cell is formed by coating a material that forms the organic photoelectric conversion layer. As described in Patent Document 1, when an organic photoelectric conversion layer including a perovskite compound is formed on a surface of a solar cell having a texture structure by coating, a uniform coating film cannot be formed in some cases. Particularly, a pinhole of the coating film is formed at the vertex of the texture structure, whereby the photoelectric conversion efficiency of the perovskite solar cell may be lowered. In addition to a case where a perovskite solar cell is stacked, the performance of a solar cell may be reduced by poor coating even in a case where a resist for insulation is applied to the solar cell having a texture structure.

Therefore, it is an object of the present invention to provide a solar cell with high photoelectric conversion efficiency.

### Means for Solving the Problems

A solar cell according to an embodiment of the present invention includes a semiconductor substrate and a first semiconductor layer having first conductivity and a second semiconductor layer having second conductivity that are stacked on the semiconductor substrate, and a material volume Vmp at 10% of an areal material ratio of at least a first main surface of the semiconductor substrate is 0.003 µm³/µm² or more and 0.010 µm³/µm² or less.

In the above solar cell, the first semiconductor layer and the second semiconductor layer may be stacked on main surfaces that differ from each other.

The solar cell may further include an organic photoelectric conversion layer that is stacked on the first main surface side and includes a perovskite compound.

The above-described solar cell may have a texture structure having a plurality of pyramidal projections on the second main surface of the semiconductor substrate.

The solar cell may receive light from the first main surface side.

### Effects of the Invention

According to the present invention, a solar cell with high photoelectric conversion efficiency can be provided.

### BRIEF DESCRIPTION OF THE DRAWINGS

FIG. 1 is a schematic cross-sectional view showing a solar cell according to an embodiment of the present invention; and
FIG. 2 is a graph showing a reflectance reduction rate and the number of uncoated portions of the semiconductor substrate in a processing example.

### PREFERRED MODE FOR CARRYING OUT THE INVENTION

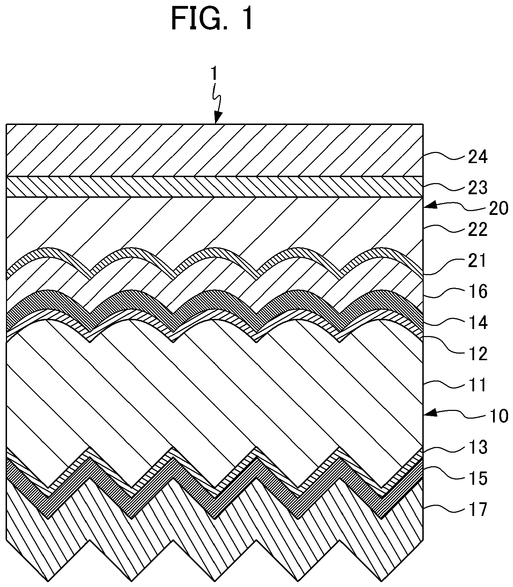

Hereinafter, embodiments of the present invention will be described with reference to the attached drawings. FIG. 1 is a schematic cross-sectional view showing a solar cell 1 according to an embodiment of the present invention.

The solar cell 1 includes a crystalline silicon solar cell unit 10 and a perovskite solar cell unit 20 stacked on the light receiving surface side of the crystalline silicon solar cell unit 10 (front surface side: the upper side in FIG. 1). In the solar cell 1, the crystalline silicon solar cell unit 10 and the perovskite solar cell unit 20 are connected in series. In the solar cell 1, first, incident light is photoelectrically converted in the perovskite solar cell unit 20, and light transmitted through the perovskite solar cell unit 20 without being converted into electric power in the perovskite solar cell unit 20 is converted into electric power in the crystalline silicon solar cell unit 10, whereby a relatively high photoelectric conversion efficiency is achieved as a whole.

The crystalline silicon solar cell unit 10 may include a structure having: a semiconductor substrate 11; a first passivation layer 12 stacked on a first main surface of the semiconductor substrate 11 on a light receiving surface side; a second passivation layer 13 stacked on a second main surface opposite to the first main surface of the semiconductor substrate 11 (back surface side: lower side in FIG. 1); a first semiconductor layer 14 stacked on the first passivation layer 12 and having first conductivity; a second semiconductor layer 15 stacked on the second passivation layer 13 and having second conductivity; an intermediate electrode layer 16 stacked on the first semiconductor layer 14; and a back surface electrode layer 17 stacked on the second semiconductor layer 15.

The perovskite solar cell unit 20 may include a structure having a first charge transport layer 21, an organic photoelectric conversion layer 22 stacked on the first charge transport layer 21, a second charge transport layer 23, and a surface electrode layer 24 in this order from the crystalline silicon solar cell unit 10 side.

The semiconductor substrate 11 can be formed of a crystalline silicon material such as monocrystalline silicon or polycrystalline silicon. The semiconductor substrate 11 may be formed of another semiconductor material such as gallium arsenide (GaAs). The semiconductor substrate 11 may be an n-type semiconductor substrate, in which, for example, a crystalline silicon material is doped with an n-type dopant. Examples of the n-type dopant include phosphorus (P). The semiconductor substrate 11 functions as a photoelectric conversion substrate that absorbs incident light from the light receiving surface side to generate photocarriers (electrons and holes). Since crystalline silicon is used as a material of the semiconductor substrate 11, a relatively high output (a stable output regardless of illuminance) can be obtained even when dark current is relatively small and the intensity of incident light is low. The thickness of the semiconductor substrate 11 may be, for example, 50 um or more and 300 um or less.

On the first main surface, the semiconductor substrate 11 has a projection-recess structure having a plurality of projections having top portions thereof rounded. On the second main surface, the semiconductor substrate 11 of the present embodiment has a texture structure having a plurality of pyramidal projections.

The projection-recess structure of the first main surface of the semiconductor substrate 11 reduces the reflectance of light and increases an amount of light incident into the inside of the semiconductor substrate 11, thereby improving the photoelectric conversion efficiency of the crystalline silicon solar cell unit 10 and, furthermore, the solar cell 1. Further, since the top portions of the projections forming the projection-recess structure are rounded, when forming a coating film on a surface of the first main surface or a layer which is stacked in a uniform thickness on the first main surface so as to conform to the first main surface of the semiconductor substrate 11, i.e., a surface of the intermediate electrode layer 16 in the present embodiment, pinholes are less likely to occur in the coating film during formation of the coating film. As a result, even when the perovskite solar cell portion 20 is formed by coating, defects are less likely to occur in the perovskite solar cell portion 20, so that a decrease in the photoelectric conversion efficiency of the solar cell 1 can be suppressed. Valley portions of the projection-recess structure of the first main surface of the semiconductor substrate 11 may have a V-shaped cross section forming a clear bottom line as shown in FIG. 1, or may be rounded similarly to the top portions.

A lower limit of the material volume Vmp at an areal material ratio of 10% of the first main surface is preferably 0.003 µm³/µm², and more preferably 0.005 µm³/µm². On the other hand, an upper limit of the material volume Vmp at an areal material ratio of 10% of the first main surface is preferably 0.010 µm³/µm², and more preferably 0.008 µm³/µm². The "material volume Vmp" is a peak volume measured in accordance with ISO25178 and the "areal material ratio" is a ratio of a material area at a height c (an area of a region whose height is equal to or greater than c). By setting the material volume Vmp at the areal material ratio of 10% of the first main surface to be equal to or greater than the lower limit, the reflectance of light can be reduced as compared with a case where the first main surface is smooth, resulting in improvement in the photoelectric conversion efficiency of the crystalline silicon solar cell unit 10. Further, by setting the material volume Vmp at the areal material ratio of 10% of the first main surface to the upper limit or less, it is possible to effectively suppress pinhole occurrence during formation of the coating film.

A root mean square height Sq (ISO25178) of the projection-recess structure of the first main surface is, for example, 0.02 um or more and 0.25 um or less. The number of projections per 10 um square is, for example, 5 or more and 40 or less. By satisfying these conditions, it is easy to set the material volume Vmp at the areal material ratio of 10% of the first main surface to the above-described range.

The projection-recess structure of the semiconductor substrate 11 can be formed by anisotropic etching of a crystalline silicon substrate having a smooth first main surface and a smooth second main surface to form a pyramidal texture structure at least on the first main surface, and then rounding the top portions of the pyramidal texture by polishing the first main surface. The polishing of the semiconductor substrate 11 is preferably performed by chemical mechanical polishing using a chemical solution that erodes the semiconductor substrate 11. Thereby, the texture can be smoothly rounded and the material volume Vmp at the areal material ratio of 10% of the first main surface can be relatively easily set to the above range. As the chemical solution used for chemical mechanical polishing of the semiconductor substrate 11 made of a crystalline silicon substrate, a mixed solution of nitric acid and hydrofluoric acid is preferably used.

The texture structure of the second main surface of the semiconductor substrate 11 can be formed by anisotropic etching of the crystalline silicon substrate. That is, unlike the first main surface, the second main surface of the semiconductor substrate 11 may be a non-polished surface. In a case where coating is not performed on the second main surface side of the semiconductor substrate 11 in the manufacturing process of the solar cell 1, since the second main surface has a texture structure, the reflectance of light can be made lower than that of the second main surface. In a case where light transmitted through the back surface side of the solar cell 1 is made incident on the solar cell 1 by providing a reflective layer on the back surface side of the solar cell 1, provision of the texture structure on the second main surface of the semiconductor substrate 11 improves utilization rate of the light, resulting in further improvement in the photoelectric conversion efficiency of the solar cell 1. Further, in order to form the above-described projection-recess structure on the first main surface of the semiconductor substrate 11, anisotropic etching of only one surface of the crystalline silicon substrate costs more than anisotropic etching of both surfaces. Thus, provision of a texture structure on the second main surface of the semiconductor substrate 11 enables improvement in the productivity and inexpensive provision of the solar cell 1.

The first passivation layer 12 and the second passivation layer 13 suppress recombination of carriers at the interface between the semiconductor substrate 11 and the first semiconductor layer 14 or second semiconductor layer 15. The first passivation layer 12 and the second passivation layer 13 may be intrinsic semiconductor thin layers formed from amorphous silicon. The first passivation layer 12 and the second passivation layer 13 can be stacked by a method such as sputtering. The thicknesses of the first passivation layer 12 and the second passivation layer 13 may be, for example, 2 nm or more and 20 nm or less.

The first semiconductor layer 14 and the second semiconductor layer 15 collect charges with polarity different from each other by attracting carriers having polarity different from each other out of the inside of the semiconductor substrate 11. Specifically, the first semiconductor layer 14 may be formed of an n-type semiconductor, and the second semiconductor layer 15 may be formed of a p-type semiconductor. The first semiconductor layer 14 and the second semiconductor layer 15 can be formed of, for example, an amorphous silicon material containing a dopant that imparts a desired conductivity type. Examples of the p-type dopant include boron (B), and examples of the n-type dopant include phosphorus (P).

The intermediate electrode layer 16 is an electrode of the crystalline silicon solar cell unit 10 and also serves as an electrode of the perovskite solar cell unit 20. The intermediate electrode layer 16 may be formed of a transparent conductive oxide (TCO: Transparent Conductive Oxide) having conductivity and light transparency in order to make light transmitted through the perovskite solar cell unit 20 enter the semiconductor substrate 11. Examples of the transparent conductive oxide forming the intermediate electrode layer 16 include indium oxide, tin oxide, zinc oxide, titanium oxide, and composite oxides thereof. Among them, indium-based composite oxide that contains indium oxide as a main component is preferable. Indium oxide is particularly preferred from the viewpoints of high conductivity and transparency. Further, it is preferable to add a dopant to indium oxide in order to ensure reliability or higher conductivity. Examples of the dopant include Sn, W, Zn, Ti, Ce, Zr, Mo, Al, Ga, Ge, As, Si and S. For example, indium tin oxide (ITO), in which tin is added to indium oxide, is widely known. The intermediate electrode layer 16 may be formed by a sputtering method, a vacuum vapor deposition method, or the like. The thickness of the positive electrode layer may be, for example, 5 nm or more and 100 nm or less.

The back surface electrode layer 17 is one electrode for outputting power from the crystalline silicon solar cell unit 10 and, furthermore, from the solar cell 1. The back surface electrode layer 17 can be formed of a conductive material, a transparent conductive oxide such as ITO, a cured product of a conductive paste such as a silver paste, or a metal such as Cu or Ni. The back surface electrode layer 17 may have a multilayer structure, and may have a structure including, for example, a layer formed of ITO excellent in adhesiveness to the second semiconductor layer 15 and a layer formed of silver paste capable of increasing the thickness easily and inexpensively and reducing the electric resistance. A method of forming the back surface electrode layer 17 is selected depending on the material, and for example, sputtering, coating, plating, or the like can be used. The thickness of the back surface electrode layer 17 may be, for example, 100 nm or more and 300 nm or less.

The first charge transport layer 21 is a hole transport layer (HTL) that selectively transmits one of the carriers generated in the organic photoelectric conversion layer 22, i.e., holes in the present embodiment, to the intermediate electrode layer 16. Examples of the main material of the first charge transport layer 21, which is the first charge transport layer, include a metal oxide such as nickel oxide (NiO) and copper oxide (Cu₂O), and organic materials such as PTAA (poly(bis(4-phenyl) (2,4,6-trimethylphenyl)amine)) and Spiro-MeOTAD. The first charge transport layer 21 may be a self-assembled monolayer (SAM) formed of, for example, 2PACz ([2-(9H-carbazol-9-yl)ethyl]phosphonic acid), MeO-2PACz ([2-(3,6-dimethoxy-9H-carbazol-9-yl)ethyl]phosphonic acid), Me-4PACz ([4-(3,6-dimethyl-9H-carbazol-9-yl)butyl ]phosphonic acid), or the like.

The first charge transport layer 21 made of a metal oxide may be formed by, for example, the sputtering method, the vacuum vapor deposition method, or the like. The first charge transport layer 21 including an organic substance may be formed by, for example, coating and drying an organic substance solution. In particular, when the first charge transport layer 21 is formed by coating and drying a solution, since a coating film without pinholes can be formed due to the reduced material volume Vmp of the semiconductor substrate 11 as described above, it is possible to prevent defects from being formed in the perovskite solar cell unit 20 and to improve the photoelectric conversion efficiency of the perovskite solar cell unit 20 and, furthermore, the solar cell 1. The thickness of the first charge transport layer 21 may largely vary depending on the material thereof, the structure of the adjacent layers, and the like, but may be, for example, 1 nm or more and 200 nm or less. In particular, in the case of the self-assembled monomolecular film, the thickness may be that of the material molecule.

The organic photoelectric conversion layer 22 includes a perovskite compound, and thus, absorbs light and generates carriers. As the perovskite compound included in the organic photoelectric conversion layer 22, a compound represented by ABX₃ can be used, the compound including an organic atom A including at least one of a monovalent organic ammonium ion or an amidinium-based ion, a metal atom B producing a divalent metal ion, and a halogen atom X including at least one of an iodide ion I, a bromide ion Br, a chloride ion Cl, or a fluoride ion F.

The organic photoelectric conversion layer 22 may be formed by, for example, the vapor deposition method or the like, but it is assumed that the organic photoelectric conversion layer 22 is formed by a method such as a sol-gel method including application of a solution (a method of synthesizing a perovskite compound in a coating film), or a coating method (a method of coating a solution containing a perovskite compound synthesized in advance). In a case where the organic photoelectric conversion layer 22 is formed by application of a solution, since the material volume Vmp of the semiconductor substrate 11 is reduced as described above, it is possible to form the organic photoelectric conversion layer 22 without a pinhole and uneven distribution of the perovskite compound, improving the photoelectric conversion efficiency of the perovskite solar cell unit 20 and, furthermore, the solar cell 1. The thickness of the organic photoelectric conversion layer 22 is preferably 100 nm or more and 1,000 nm or less in order to increase light absorptivity and reduce travel distance of generated charges, although it depends on the material for forming the organic photoelectric conversion layer 22.

The second charge transport layer 23 is an electron transport layer (ETL) that selectively transmits carriers, i.e., electrons in the present embodiment, generated in the organic photoelectric conversion layer 22 to the surface electrode layer 24. Examples of the main material of the second charge transport layer 23 as the electron transport layer include PTAA (poly(bis(4-phenyl)(2,4,6-trimethylphenyl)amine)), Spiro-MeOTAD, fullerene, and the like. Examples of the fullerene include C60, C70, hydrides, oxides, and metal complexes thereof, and derivatives thereof having an alkyl group and the like added thereto. The electron transport efficiency can be improved by forming the second charge transport layer 23 from a material containing fullerene including lithium Li encapsulated therein. The second charge transport layer 23 may be formed by, for example, the sol-gel method or the coating method. The thickness of the second charge transport layer 23 may be, for example, 3 nm or more and 30 nm or less.

The surface electrode layer 24 is an electrode paired with the intermediate electrode layer 16 in the perovskite solar cell unit 20. The surface electrode layer 24 is a transparent electrode that transmits light incident through an antireflection layer 33, and can be formed using the same material as the intermediate electrode layer 16 by the same method as the intermediate electrode layer 16. The thickness of the surface electrode layer 24 may be, for example, 500 nm or more and 1,000 nm or less.

The solar cell 1 having the above-described configuration has the material volume Vmp of the first main surface of the semiconductor substrate 11 set within the above-described range, thereby having good coating properties during formation of the first charge transport layer 21 and the organic photoelectric conversion layer 22, resulting in few defects and excellent photoelectric conversion efficiency.

Although the embodiments of the present invention have been described above, the present invention is not limited to the embodiments described above, and various changes and modifications are possible. For example, in the solar cell according to the present invention, the surface shape of the second main surface of the semiconductor substrate is not particularly limited, and may have a projection-recess structure having a material volume Vmp similar to that of the first main surface, or may have a smooth mirror-like surface. The solar cell according to the present invention may lack some layers, such as a perovskite solar cell unit or the like, and may have an additional layer, such as an anti-reflective layer stacked on the light receiving surface. The solar cell according to the present invention may be a so-called back contact solar cell, in which the first semiconductor layer and the second semiconductor layer are provided in a complementary shape on the back surface side of the semiconductor substrate. Further, in the solar cell according to the present invention, the first main surface having the material volume Vmp described above may be a surface opposite to the light receiving surface. For example, in a case where a reflective layer is provided on the back surface side of a back contact solar cell, and light transmitted into the back surface side is made incident on the semiconductor substrate again, the present invention can improve the absorptivity of light from the back surface side while facilitating the formation of a resist or the like during patterning of the first semiconductor layer and the second semiconductor layer.

### EXAMPLES

However, the present invention is not limited to the following examples.

The following semiconductor substrates were experimentally produced: a mirror-finished crystalline silicon substrate (substrate No. 1); substrates including a texture structure formed by anisotropic etching of a crystalline silicon substrate (substrate Nos. 2 to 4); and semiconductor substrates obtained by chemical mechanical polishing of a surface including the texture structure formed (substrate Nos. 5 to 8). For each semiconductor substrate, a material volume Vmp at an areal material ratio of 10% and a rate of reduction in the reflectance of light at a wavelength of 800 nm compared with the mirror-finished substrate were measured. Further, after applying a solution containing a perovskite compound to each semiconductor substrate, the surface was observed with a microscope to count the number of non-coated portions (pinholes) in a region of 50 um square. The results of these measurements are shown in the following table.

**[Table 1]**

| Substrate number | Material volume [µm³/µm²] | Reflectance reduction rate [%] | Number of uncoated portions [portions] |
|---|---|---|---|
| 1 | 0.002 | 0 | 0 |
| 2 | 0.012 | 8.8 | 2 |
| 3 | 0.018 | 46.5 | 6 |
| 4 | 0.036 | 70.8 | 5 |
| 5 | 0.003 | 4.2 | 0 |
| 6 | 0.006 | 4.1 | 0 |
| 7 | 0.007 | 5.4 | 0 |
| 8 | 0.010 | 6.1 | 0 |

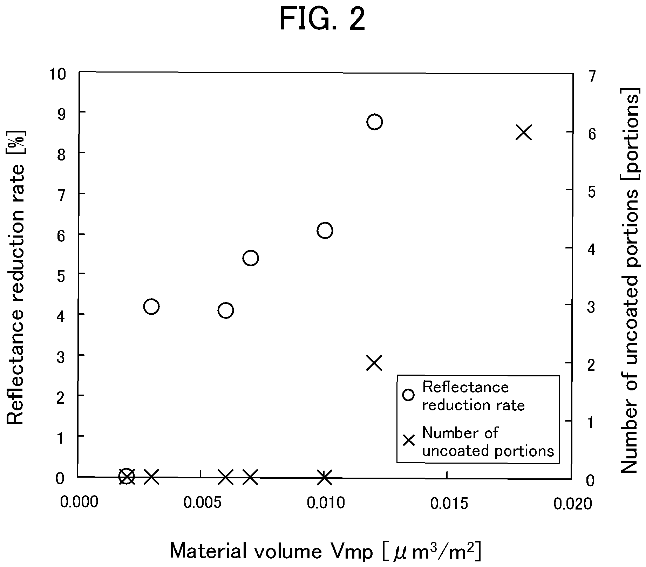

Further, the material volume Vmp in a range where the material volume Vmp is small and the reflectance reduction rate are shown in FIG. 2. As shown in the figure, by setting the material volume Vmp to 0.003 or more, it is considered that the reflectance can be reduced and the photoelectric conversion efficiency of the solar cell can be improved as compared with the mirror-finished crystalline silicon substrate. In addition, since defects do not occur in the coating film by setting the material volume Vmp to 0.010 or less, it is considered that a decrease in the photoelectric conversion efficiency due to a manufacturing defect of the solar cell can be prevented.

### EXPLANATION OF REFERENCE NUMERALS

1 Solar Cell
10 Crystalline silicon solar cell unit
11 Semiconductor substrate
12 First passivation layer
13 Second passivation layer
14 First semiconductor layer
15 Second semiconductor layer
16 Intermediate electrode layer
17 Back surface electrode layer
20 Perovskite solar cell unit
21 First charge transport layer
22 Organic photoelectric conversion layer
23 Second charge transport layer
24 Surface electrode layer

## Claims

1. A solar cell, comprising:
a semiconductor substrate; and
a first semiconductor layer having first conductivity and a second semiconductor layer having second conductivity that are stacked on the semiconductor substrate,
wherein a material volume Vmp at 10% of an areal material ratio of at least a first main surface of the semiconductor substrate is 0.003 µm³/µm² or more and 0.010 µm³/µm² or less.

2. The solar cell according to claim 1, wherein the first semiconductor layer and the second semiconductor layer are stacked on main surfaces that differ from each other.

3. The solar cell according to claim 2, further comprising an organic photoelectric conversion layer stacked on a first main surface side and comprising a perovskite compound.

4. The solar cell according to any one of claims 1 to 3, wherein light is received from a first main surface side.

5. The solar cell according to any one of claims 1 to 4, having a texture structure having a plurality of pyramidal projections on a second main surface of the semiconductor substrate.
